(19) **Europäisches Patentamt / European Patent Office / Office européen des brevets**

(11) **EP 4 520 717 A1**

(12) # DEMANDE DE BREVET EUROPEEN

(43) Date de publication:
**12.03.2025 Bulletin 2025/11**

(21) Numéro de dépôt: **23195373.8**

(22) Date de dépôt: **05.09.2023**

(51) Classification Internationale des Brevets (IPC):
**B81C 1/00** (2006.01)

(52) Classification Coopérative des Brevets (CPC):
**B81C 1/00396; B81C 1/00619;** B81B 2203/033;
B81C 2201/0132

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**
Etats d'extension désignés:
**BA**
Etats de validation désignés:
**KH MA MD TN**

(71) Demandeur: **Patek Philippe SA Genève**
**1204 Genève (CH)**

(72) Inventeurs:
• **DUBOCHET, Olivier**
  **2562 Port (CH)**
• **PÉTREMAND, Yves**
  **1400 Yverdon-les-Bains (CH)**
• **JEANNERET, Sylvain**
  **1228 Plan-les-Ouates (CH)**

(74) Mandataire: **Micheli & Cie SA**
**Rue de Genève 122**
**Case Postale 61**
**1226 Genève-Thônex (CH)**

(54) **PROCÉDÉ DE FABRICATION D'UN COMPOSANT HORLOGER EN MATÉRIAU SANS DÉFORMATION PLASTIQUE, NOTAMMENT EN SILICIUM**

(57) La présente invention concerne un procédé de fabrication d'au moins un composant micromécanique en matériau sans déformations plastiques, notamment en silicium, comprenant la dépose de trois couches successives : couche d'oxyde, couche métallique et couche de résine photosensible. Des masques de gravure sont réalisés successivement dans les couches, le dernier de ces masques servant à graver le composant souhaité. Le procédé permet de réaliser un composant micromécanique comprenant une structuration formée d'au moins une ouverture dont le rapport d'aspect est supérieur à 20, favorablement supérieur à 50, encore plus favorablement supérieur à 100.

## Fig. 2

EP 4 520 717 A1

## Description

La présente invention a pour objet un procédé de fabrication d'un composant horloger dans un matériau sans déformation plastique, notamment en silicium.

Le silicium est un matériau très apprécié dans l'horlogerie mécanique pour ses propriétés avantageuses, notamment sa faible densité, sa grande résistance à la corrosion, son caractère amagnétique et son aptitude à être usiné par des techniques de micro-fabrication. On l'utilise ainsi pour fabriquer notamment des ressorts spiraux, des balanciers, des oscillateurs à guidage flexible, des ancres d'échappement, des roues d'échappement et une multitude d'autres composant micromécaniques horlogers.

Le micro-usinage du silicium consiste en grande partie en des opérations de gravures. Une première étape de fabrication consiste à se munir d'un substrat en silicium en forme de plaque. Bien entendu, le substrat pourrait ne pas être entièrement constitué de silicium ou encore être constitué par du silicium dopé. Le substrat pourrait être formé de silicium sur isolant (du SOI selon son abréviation anglaise). Un tel substrat à structure sandwich comporte deux couches de silicium reliées par une couche intermédiaire en oxyde de silicium. Le substrat pourrait alternativement être constitué d'une couche de silicium rapportée sur un autre type de base comme par exemple du métal.

L'étape suivante du procédé consiste à déposer et à réaliser un masque de gravure ajouré sur une surface horizontale du substrat. Le masque est formé à partir d'un matériau capable de résister aux étapes de gravure subséquentes. Par exemple, le masque de gravure est réalisé en oxyde de silicium. Le masque de gravure est en général obtenu par un procédé de photolithographie. Le substrat est d'abord oxydé, puis une couche de résine photosensible est déposée sur une surface horizontale du substrat et ensuite exposée à un rayonnement (en général UV) à travers un masque d'exposition (aussi appelé photomasque ou réticule). L'exposition crée des réactions au sein de la résine et engendre des modifications chimiques, les zones irradiées vont voir leur solubilité évoluer suivant le type de résine (positive ou négative). Un développeur va permettre d'éliminer la résine exposée ou non selon sa solubilité et ainsi former un masque de résine sur le substrat. On grave ensuite la couche d'oxyde de silicium à travers le masque de résine par gravure plasma pour former le masque de gravure.

Dans l'étape suivante, on grave le substrat à travers ce masque de gravure selon le procédé de gravure ionique réactive profonde DRIE de manière à former le composant micromécanique souhaité ou un ensemble de composant micromécaniques souhaités dans le substrat. On enlève ensuite le masque de gravure. Pour une plaque silicium sur isolant ou silicium sur base, on libère la couche qui a été gravée de la couche de support ainsi que les différents composant micromécaniques formés.

Il est également possible de graver le substrat en silicium directement à travers un masque de résine, sans couche d'oxyde de silicium, pour une profondeur de gravure allant par exemple jusqu'à 200 $\mu$m voire 300 $\mu$m environ.

Une étape supplémentaire peut être prévue consistant à revêtir les composant micromécaniques d'une couche de dioxyde de silicium sur toute leur surface extérieure pour augmenter leur résistance mécanique. Cette étape est réalisée par un traitement de surface tel qu'un traitement d'oxydation thermique, un dépôt chimique en phase vapeur (CVD selon l'abréviation anglaise chemical vapour déposition) ou un dépôt physique en phase vapeur (PVD selon l'abréviation anglaise physical vapour déposition), afin d'obtenir une couche de dioxyde de silicium d'épaisseur supérieure à la couche de dioxyde de silicium dit « natif » se formant naturellement en présence d'air. L'épaisseur de la couche de dioxyde de silicium est de préférence au moins égale à 0,5 micromètre.

Le procédé de fabrication ci-dessus a prouvé son intérêt depuis plusieurs années et la fabrication des pièces est de plus en plus précise. Cependant, le développement de nouveaux mécanismes et l'usage extensif du silicium pour de nombreux composant micromécaniques poussent à atteindre des définitions et des précisions de fabrication encore meilleures.

A titre d'exemple, il est difficile aujourd'hui d'atteindre des précisions de fabrication inférieure à 3 $\mu$m. De plus, les épaisseurs minimales de parois que l'on peut fabriquer sont de l'ordre 15 $\mu$m pour un composant micromécanique de hauteur 120 $\mu$m, pour un rapport d'aspect (hauteur sur largeur) de 8. Il est donc quasi impossible de structurer des pièces très fines. Par structurer, on entend réaliser au moins une structure mais de préférence plusieurs structures répétées dans la pièce pour l'alléger ou modifier certaines de ses propriétés physiques ou mécaniques (diminuer la masse ou l'inertie ou modifier la rigidité par exemple). De telles structurations pour être efficaces devraient avoir des dimensions de quelques micromètres de large pour quelques centaines de micromètres de haut (rapport d'aspect supérieur à 20, 50 voire 100).

En plus de la précision, on cherche aussi à garantir une grande fiabilité dans la production. Avec la technique de micro-fabrication décrite ci-dessus, il est possible de fabriquer plusieurs dizaines voire centaines de composant micromécaniques identiques sur une même plaque. Cependant, les procédés comme la gravure DRIE entraînent une certaine dispersion géométrique entre les dimensions des composant micromécaniques d'une même plaque. Cette dispersion peut être critique pour des composant micromécaniques nécessitant une grande homogénéité dimensionnelle sur l'ensemble d'une plaque. Par exemple, lors de la fabrication de spiraux en silicium, il existe une dispersion entre la raideur des spiraux gravés. Cette dispersion forme des classes de spiraux. Le rendement final est donc donné par le nombre de composant micromécaniques dont les dimensions satisfont un intervalle de tolérance donné. Actuellement, la dispersion des classes implique qu'il faut fabriquer un plus grand nombre de spiraux par rapport au nombre de balanciers pour former des oscillateurs balancier-spiraux adéquats. Pour augmenter le rendement, il serait donc intéressant de diminuer la dispersion géométrique lors de la fabrication des composant micromécaniques.

Un but de la présente invention est donc de fournir un procédé de fabrication de composant micromécaniques horlogers en matériau sans déformations plastiques, notamment en silicium qui remédie aux inconvénients ci-dessus et en particulier, qui offre une grande précision et définition de fabrication.

La présente invention a pour objet un procédé de fabrication d'un composant horloger en matériau sans déformations plastiques et notamment en silicium selon la revendication 1.

D'autres caractéristiques et avantages de la présente invention apparaîtront à la lecture de la description qui va suivre, donnée uniquement à titre d'exemple non limitatif, et faite en référence aux dessins annexés dans lesquels :

La figure 1 illustre schématiquement les différentes étapes d'un procédé de fabrication d'un ou plusieurs composant micromécaniques en silicium selon un mode de réalisation préféré de l'invention.

La figure 2 illustre une structuration d'un composant horloger en silicium obtenue au moyen du procédé selon l'invention.

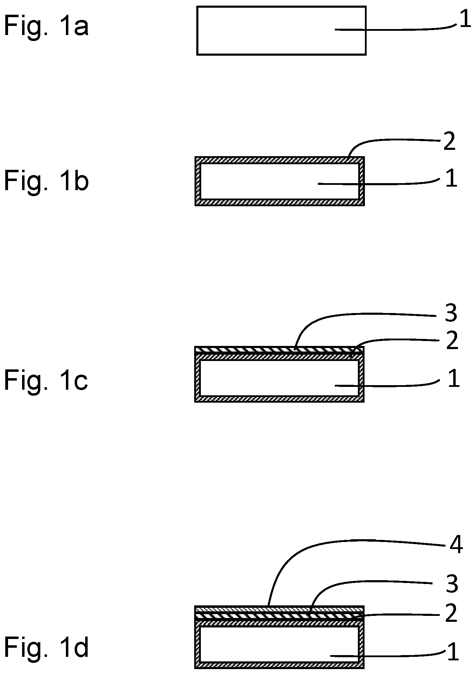

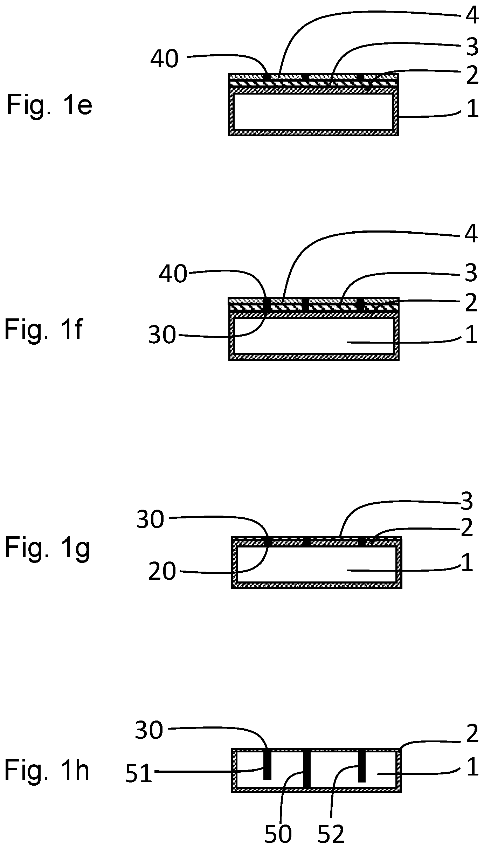

La figure 1 montre les différentes étapes du mode de réalisation préféré du procédé selon l'invention.

A une première étape (figure 1a), on prépare par exemple une plaque de silicium 1 présentant de préférence une épaisseur équivalente à celle des composant micromécaniques à fabriquer. En variante, la plaque pourrait ne pas être entièrement constituée de silicium ou encore être constituée par du silicium dopé. La plaque pourrait encore être une plaque de silicium sur isolant (SOI selon son abréviation anglaise silicon on insulator). La plaque pourrait alternativement être constituée d'une couche de silicium rapportée sur un autre type de base comme par exemple du métal. Le silicium peut être mono- ou polycristallin.

Dans une seconde étape (figure 1b), la plaque 1 est oxydée pour former une couche d'oxyde de silicium 2. Cette étape peut être notamment réalisée par un traitement de surface tel qu'un traitement d'oxydation thermique, un dépôt chimique en phase vapeur (CVD) ou un dépôt physique en phase vapeur (PVD), afin d'obtenir une couche de dioxyde de silicium d'épaisseur supérieure à la couche de dioxyde de silicium dit « natif » se formant naturellement en présence d'air.

Sur cette couche d'oxyde de silicium 2, on applique dans une troisième étape (figure 1c) une couche métallique 3. De préférence, la couche métallique 3 est une couche de chrome pulvérisée ou évaporée par une méthode de dépôt physique en phase vapeur (PVD). En variante, la couche métallique 3 pourrait être une couche de titane ou de tantale déposée directement sur la couche d'oxyde de silicium 2 sans couche d'accroche préalable ou encore une couche de nickel, d'aluminium, d'iridium ou de tungstène déposée sur une couche d'accroche préalablement déposée sur la couche d'oxyde de silicium 2.

Dans une quatrième étape (figure 1d), une couche de résine photosensible 4 (dans la suite simplement résine) est déposée sur la couche métallique 3.

La cinquième étape (figure 1e) est une étape de photolithographie durant laquelle la couche de résine 4 est exposée à un rayonnement (typiquement UV) à travers un masque d'exposition ou réticule. De préférence, cette étape de photolithographie se fait à l'aide d'un stepper. Ce système, abréviation de l'anglais step-and-repeat caméra ou step-and-scan caméra pour les versions les plus récentes, fonctionne à la manière d'un projecteur de diapositives. Le composant micromécanique à fabriquer - comme par exemple un composant horloger tel une ancre, un spiral, un balancier, une roue, un ressort, un élément du bâti ou de la platine- est reproduit à large échelle sur un réticule (la diapositive). Le réticule est robuste et reproduit fidèlement toutes les dimensions et structures formant le composant micromécanique à fabriquer. Le réticule est positionné par rapport à la plaque 1 et à la couche de résine 4, une source lumineuse insole la couche de résine 4 à travers le réticule et un système de lentilles qui réduisent l'image projetée (généralement, entre 4 et 10 fois). Le stepper déplace ensuite le réticule par rapport à la plaque 1 et répète le processus. On obtient ainsi dans la couche de résine 4 un premier masque de gravure 40 comprenant, répétées de nombreuses fois, l'image précise du motif présent sur le réticule. L'utilisation d'un stepper permet une très haute définition, résolution et précision dans la création du premier masque de gravure 40.

Les étapes suivantes du procédé sont des étapes de gravure.

Dans la sixième étape (figure 1f), la couche métallique 3 est gravée à travers le premier masque de gravure 40 formé dans la couche de résine 4. La technique utilisée est par exemple une technique de gravure ionique réactive (RIE). On obtient ainsi un second masque de gravure 30 dans la couche métallique 3 dans lequel les images précises et répétées du premier masque de gravure 40 sont transférées avec de très hautes précision et résolution. Durant cette étape, au moins une partie de la couche de résine 4 est consommée.

Dans la septième étape (figure 1g), on utilise le second masque de gravure 30 dans la couche métallique 3 pour graver la couche d'oxyde de silicium 2 pour former un troisième masque de gravure 20 dans la couche d'oxyde de silicium 2. Un procédé de gravure plasma peut par exemple être utilisé. Durant cette étape, le reste de la couche de résine 4 est en général entièrement consommée ainsi qu'une partie ou la totalité de la couche métallique 3.

Enfin, dans une huitième étape (figure 1h), le troisième masque de gravure 20 permet la gravure de la plaque en silicium 1 par gravure ionique réactive profonde (DRIE). On forme ainsi le composant micromécanique souhaité ou un ensemble de composant micromécaniques souhaités dans la plaque 1. Durant cette étape, une partie ou la totalité de la couche d'oxyde 2 est consommée. Les ouvertures 50, 51, 52 formées dans la plaque 1 de silicium et faisant partie du composant micromécanique souhaité peuvent être traversantes (50) ou borgnes avec différentes profondeurs (51, 52).

Une étape supplémentaire (non illustrée) peut être prévue consistant à revêtir les composant micromécaniques d'une couche de dioxyde de silicium sur toute leur surface extérieure pour augmenter leur résistance mécanique. Cette étape est réalisée par un traitement de surface tel qu'un traitement d'oxydation thermique, un dépôt chimique en phase vapeur (CVD) ou un dépôt physique en phase vapeur (PVD), afin d'obtenir une couche de dioxyde de silicium d'épaisseur supérieure à la couche de dioxyde de silicium dit « natif » se formant naturellement en présence d'air. L'épaisseur de cette couche de dioxyde de silicium finale est de préférence au moins égale à 0.5 micromètre.

Tout autre traitement supplémentaire peut être appliqué aux composant micromécaniques obtenus après la huitième étape ou après l'étape supplémentaire de compensation thermique ci-dessus. On peut citer en particulier un traitement consistant à arrondir les arêtes tel que décrit dans CH 699 476 incorporé ici par référence.

En considérant le procédé de fabrication ci-dessus, on comprend que chacune des couches d'oxyde 2, métallique 3 et de résine 4 doit présenter une épaisseur suffisante pour être capable de servir de masque de gravure et donc de résister jusqu'à ce que la couche inférieure soit ouverte ou gravée. En particulier, l'épaisseur de la plaque 1 (et donc en général l'épaisseur du composant micromécanique à fabriquer) va déterminer l'épaisseur nécessaire pour la couche d'oxyde 2. On choisit ensuite l'épaisseur de la couche métallique 3 en fonction de l'épaisseur de la couche d'oxyde 2 et l'épaisseur de la couche de résine 4 en fonction de l'épaisseur de la couche métallique 3. Comme la couche d'oxyde 2 est en général nettement plus fine que l'épaisseur de la plaque 1, les couches de chrome 3 et de résine 4 pourront également être très fines par rapport à l'épaisseur de la plaque 1.

Par exemple, pour une plaque 1 de 120 $\mu$m (c'est-à-dire pour un composant micromécanique à fabriquer de la même épaisseur), la couche d'oxyde 2 peut présenter une épaisseur comprise de préférence entre 0.4 et 3 $\mu$m. La couche métallique 3 déposée sur la couche d'oxyde peut alors présenter une épaisseur de quelques centaines de nanomètres, entre 100 et 500 nanomètres de préférence 100 nanomètres. Enfin, la couche de résine 4 peut être la plus fine possible, avec une épaisseur entre 0.1 et 5 $\mu$m plus favorablement entre 0.2 et 3 $\mu$m et de manière encore plus privilégiée entre 0.4 et 0.8 $\mu$m.

On comprend que l'épaisseur des couches d'oxyde de silicium 2, métallique 3, de résine 4 dépendent de l'épaisseur de la plaque et/ou de la profondeur de la gravure finale souhaitée. De manière générale, l'épaisseur de la plaque 1 peut varier et peut notamment aller jusqu'à 300 $\mu$m ou plus.

Les valeurs données ci-dessus ne sont que des exemples et pourront varier selon le matériau de la plaque et/ou le résultat recherché.

Avec cette succession de couches très fines, il est possible de transférer les caractéristiques de précision, définition et résolution du premier masque de gravure 40 réalisé dans la couche de résine 4 à chacun des second et troisième masques de gravure 30, 20 puis à la plaque 1.

En effet, pour reproduire précisément la géométrie du premier masque de gravure 40 dans la couche métallique 3, le flanc de gravure doit être le plus vertical possible. Or, plus la couche de résine 4 est fine plus cela sera le cas. Par conséquent, avec une couche de résine 4 fine, il est possible de transférer aisément la précision, définition et résolution du premier masque de gravure 40 en résine dans le second masque de gravure 30 métallique. Le même raisonnement s'applique pour réaliser le troisième masque de gravure 20 dans la couche d'oxyde 2. Avec un second masque de gravure 30 métallique très fin, on s'assure d'une gravure précise avec une haute définition et résolution lors la reproduction des motifs du second masque de gravure 30 métallique sur la couche d'oxyde 2.

Cette caractéristique du procédé selon l'invention permet avantageusement de structurer un composant micromécanique. Comme indiqué en introduction, il peut être intéressant de réaliser au moins une mais de préférence plusieurs structures fines répétées dans un composant horloger pour l'alléger ou modifier certaines de ses propriétés physiques ou mécaniques (inertie, masse, rigidité dans différentes directions, ...). Par structure fine, on entend une ouverture d'une largeur en dessous de 5 $\mu$m, typiquement entre 2 et 3 $\mu$m. Ces ouvertures peuvent être traversantes (c'est-à-dire ouvertes sur chaque côté du composant horloger) ou alors borgnes. Comme indiqué plus haut, on adapte la profondeur de la ou des structures en jouant sur l'épaisseur des masques de gravures successifs.

En structurant un composant horloger, on peut notamment réduire son poids ou son inertie tout en garantissant une même rigidité ce qui peut être intéressant pour les rouages à haute vitesse de rotation pour lesquels le silicium est déjà utilisé pour réduire l'inertie.

Dans un autre exemple, le ressort spiral est sensible à la gravité, en particulier dans les marches verticales. Sa masse a été fortement réduite en passant d'un spiral métallique à un spiral en silicium. La masse du spiral, $m_s$, est proportionnelle au rapport $\rho/E^{1/3}$, où $\rho$ est la densité et E, le module d'élasticité. Il est donc envisageable de réduire la masse du spiral en modifiant le module d'élasticité apparent de la lame ressort, grâce à une structuration de celle-ci.

Un autre avantage de la structuration d'un composant horloger en silicium est de créer des ouvertures fines dans lesquelles on peut faire croitre de l'oxyde de silicium dans un but de compensation thermique. L'effet de compensation thermique est déterminé par le rapport entre la largeur de la pièce et l'épaisseur de la couche d'oxyde. Ainsi, avec des structures fines (ouvertures), la couche d'oxyde nécessaire sera plus fine. L'oxydation thermique est un phénomène logarithmique puisque l'oxygène qui vient oxyder le silicium doit migrer à travers la couche d'oxyde qui se crée. Par conséquent, plus la couche désirée est épaisse plus le temps d'oxydation sera long. Avec un composant horloger structuré, il est possible de réduire ce temps d'oxydation.

La structuration d'un composant horloger peut également être utile lorsqu'il s'agit de trouver un équilibre entre deux caractéristiques mécaniques. Une aiguille de chronographe par exemple se doit d'être légère pour consommer peu d'énergie et rigide pour résister mécaniquement aux remises à zéro. Une structuration appropriée de l'aiguille permettrait de moduler ce rapport entre masse et rigidité. Dans un autre exemple, les guidages flexibles à lames croisées séparées sont de plus en plus utilisés pour fabriquer des pivotements ou des oscillateurs, de type Wittrick notamment. Ces guidages doivent supporter des masses importantes. On leur demande donc d'avoir une forte rigidité hors plan de rotation, pour éviter une flexion qui peut être préjudiciable à la chronométrie. D'un autre côté, on leur demande également de garantir un couple très précis dans le plan. Une structuration appropriée permettra là encore de moduler ce rapport entre rigidité hors plan et rigidité dans le plan.

Dans un autre exemple encore, il est possible de réaliser un ressort-lame comportant au moins deux lames séparées par une structure fine ayant la forme d'une fente d'une épaisseur d'environ $1\mu m$ s'étendant sur toute la longueur active du ressort-lame. Selon le cas, la fente pourra être ouverte à l'extrémité libre du ressort-lame ou fermée (ressort-lame fixé à ces deux extrémités pour un travail en flambage). On réalise ainsi un ressort-lame qui peut fournir un effort important grâce à la multiplication des lames sans augmenter la contrainte par rapport à un ressort-lame à lame unique fournissant le même effort. Dans cet exemple également, la structure fine permet de changer la raideur du ressort-lame dans un plan (plan d'effort) sans changer la raideur hors plan de travail. De plus, la finesse de la structuration limite l'encombrement de la pièce et préserve son esthétique (la structure n'est quasi pas visible à l'œil nu).

Enfin, la structuration peut être utile pour empêcher la propagation d'une fissure dans une zone du composant horloger à forte contrainte. Le silicium, comme les autres matériaux sans déformations plastiques, est un matériau très fragile et il faut donc éviter les zones de concentration de contraintes sur le composant micromécanique. En général, pour les lames ressort notamment, les zones de contraintes maximales sont situées sur les flancs. Or, lesdits flancs usinés par DRIE sont le siège de défauts lié à la gravure (scalloping, défauts de surface). Il est possible de prévoir une structuration comprenant une ouverture proche de la surface extérieure et de la zone de forte contrainte du composant micromécanique. Cette structuration pourrait être agencée pour empêcher qu'une fissure ne se propage à l'ensemble du matériau, ne le casse de façon violente et ne crée des débris qui viendraient polluer tout le mouvement. Après la fissure arrêtée par l'ouverture de la structuration, une perte de rigidité du composant micromécanique sera forcément observée, et donc un fonctionnement moins efficace, mais cela est moins préjudiciable que des débris dans un mouvement. De même, il est possible avec une structuration adéquate d'éviter la propagation de fissures au serrage des composant micromécaniques formant un assemblage vissé, comme par exemple le talon d'un ressort, vissé dans une partie fixe du mouvement.

Comme on l'a dit, pour être efficaces et utiles, ces structurations fines devraient avoir des dimensions de quelques micromètres de large, de préférence en dessous de $5\mu m$, ou de $4.5\ \mu m$, typiquement environ 4, 3.5, 3, 2.5, 2, 1.5, 1 ou $0.5\mu m$ de large pour quelques centaines de micromètres de haut. Les parois verticales sont typiquement 20, 30, 40, 50, 60, 70, 80, 90, 100, voire supérieur ou égal à 100 fois plus hautes que la largeur de l'ouverture pour un rapport d'aspect supérieur ou égal à 20, 30, 40, 50, 60, 70, 80, 90, 100, voire supérieur ou égal à 110 ou 120. De préférence, lorsque la structuration est composée d'ouvertures fines et répétées, les parois entre chaque ouverture sont également très fines. En particulier, ces parois pourraient présenter le même rapport d'aspect que les ouvertures. Les parois pourraient dans un autre exemple présenter une largeur supérieure ou égale à $4\mu m$.

Or, une partie du masque de gravure est naturellement consommé durant une gravure DRIE. De plus, pour des structures très fines en largeur, le taux de renouvellement des gaz au fonds des trous à ouvrir diminue en fonction de la profondeur à atteindre, ce qui réduit encore la sélectivité du masque. Ainsi, si l'on ne devait utiliser qu'une seule couche de résine pour former un masque et graver des structures fines sur toute la hauteur de la plaque de silicium, il faudrait une couche de résine très épaisse pour résister à la gravure jusqu'à l'ouverture complète des structures. Or, un masque très épais n'est pas compatible avec la verticalité, la précision et la haute définition de structures fines avec un rapport d'aspect supérieur à 20, 50 ou 100.

Ainsi, le procédé selon la présente invention résout ce problème et permet de réaliser des structures fines précises et de haute définition en utilisant une succession de couches pour garantir à chaque étape de gravure une sélectivité suffisante et obtenir au final une gravure sur la plaque en silicium 1 suffisamment profonde formant des structures très fines dont le rapport d'aspect est supérieur à 20, 50 ou 100.

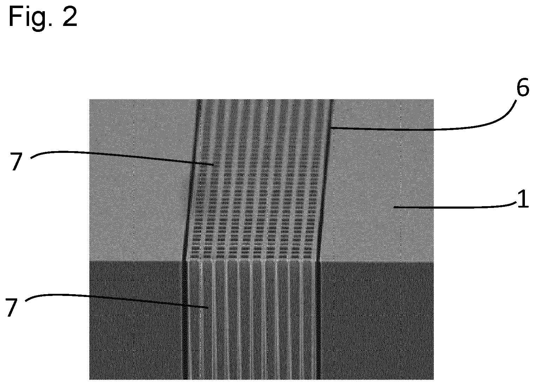

La figure 2 illustre une plaque de silicium 1 dans laquelle un composant micromécanique 6 a été gravé par le procédé selon l'invention, ledit composant micromécanique comprenant une structuration 7 formée de carrés de 5μm de largeur, ouverts sur toute la hauteur de la plaque 1 soit 120μm.

De manière générale, la structuration peut avoir une forme libre définie par la forme du premier masque de gravure 40 en résine. En particulier, la ou les structures peuvent être avoir toute forme appropriée (carré, rond, triangle etc.) et, lorsqu'elles sont répétées, peuvent être uniformes ou non en forme, dimensions et profondeur (la variation de profondeur s'obtient en adaptant l'épaisseur des différents masques de gravure). De plus, la structuration peut s'étendre sur une portion seulement du composant micromécanique jusqu'à recouvrir l'ensemble du composant micromécanique.

En outre, l'utilisation d'un stepper dans la cinquième étape du procédé de fabrication permet d'obtenir un premier masque de gravure 40 en résine avec une grande définition et une grande précision. Il est notamment possible de créer un masque de gravure en résine 40 reproduisant des structures très fines. Avec la succession de couches et d'étapes de gravure selon l'invention, ces structures très fines du premier masque de gravure 40 sont reproduites avec grande précision et haute résolution sur les second et troisième masques 30, 20 de gravures puis gravées sur la plaque 1.

De plus, avec le stepper et sa haute résolution, le premier masque de gravure 40 comprend moins de défauts sur les bordures de la ou des ouvertures. Or, avec un procédé de gravure DRIE, ces défauts sont reproduits sur toute la hauteur du flanc de coupe et constituent alors des zones à risque de rupture sur le composant micromécanique. Moins de défauts sur le masque de gravure implique donc directement moins de risques de rupture et donc une meilleure résistance mécanique pour le composant micromécanique. Le document EP 3 882 710, incorporé ici par référence, estime les propriétés mécaniques du silicium, et notamment la résistance à la rupture à plus de 6000 MPa. Le déposant relève qu'aujourd'hui les lames ressorts en silicium après post-traitement (cycles répétés d'oxydation thermique et de désoxydation) présentent des propriétés mécaniques supérieures de 4000 MPa mais que les défauts de surface dus à la gravure DRIE sont responsables de ruptures des lames en flexion. En réduisant les défauts de surface, les propriétés mécaniques sont améliorées se traduisant par un stockage d'énergie plus important. En considérant que l'énergie maximale que l'on peut stocker et restituer dans un ressort est :

$$E_{Max} = \sigma^2/E,$$

où $\sigma$ est la contrainte à rupture et E le module d'élasticité, le gain potentiel est supérieur à 100%. De même, la longueur des ressorts en silicium peut être grandement réduite par rapport à un ressort acier pour une contrainte à 4000 MPa et encore plus pour une contrainte à 6000 MPa. Cet avantage est important en horlogerie pour garder des mouvements fins.

Enfin, le stepper et sa technique d'exposition par pas successifs permettent de répéter précisément le même motif dans le premier masque de résine 40. La précision de fabrication du stepper (autour de ±20 nm par rapport à 300 nm pour un procédé de photolithographie par contact ou aligner) se traduit directement par une réduction de la dispersion géométrique des composant micromécaniques reproduits sur le premier masque de résine 40. Par exemple, dans le cadre de la fabrication de composant micromécaniques horlogers comme des spiraux en silicium, le nombre de classes de spiraux sur une même plaque 1 est fortement diminué avec l'utilisation d'un stepper. Le rendement du procédé de fabrication est donc nettement amélioré.

De manière générale, la présente invention a pour objet un procédé de fabrication d'au moins un composant micromécanique, de préférence un composant horloger, dans un matériau sans déformations plastiques, notamment en silicium, comprenant les étapes suivantes :

a) se procurer une plaque dans un matériau sans déformations plastiques ;

b) former une couche d'oxyde au moins sur une surface de la plaque ;

c) appliquer une couche métallique sur la couche d'oxyde, dans un métal offrant une grande sélectivité pour graver la couche d'oxyde, de préférence choisi parmi le chrome, le titane, le tantale ou le nickel, ou parmi l'aluminium, le tungstène ou l'iridium après dépôt d'une couche d'accroche ;

d) appliquer une couche de résine photosensible sur la couche métallique ;

e) former par lithographie un premier masque de gravure dans la couche de résine, le premier masque de gravure comportant au moins un motif correspondant au composant micromécanique à fabriquer ;

f) graver la couche métallique à travers le premier masque de gravure pour former un second masque de gravure dans ladite couche métallique ;

g) graver la couche d'oxyde à travers le second masque de gravure pour former un troisième masque de gravure dans ladite couche d'oxyde;

h) graver la plaque à travers le troisième masque de gravure pour former ledit au moins un composant micromécanique.

De préférence, l'étape de lithographie est une étape de photolithographie à l'aide d'un système de stepper.

De préférence, la couche d'oxyde peut présenter une épaisseur comprise entre 0.4 et 3 $\mu$m.

De préférence, la couche métallique déposée sur la couche d'oxyde peut présenter une épaisseur de quelques centaines de nanomètres, entre 100 et 500 nanomètres.

De préférence, la couche de résine peut présenter une épaisseur entre 0.1 et 5 $\mu$mm, plus favorablement entre 0.2 et 3$\mu$m et de manière encore plus privilégiée entre 0.4 et 0.8 $\mu$m.

De préférence, la couche métallique est gravée par une technique de gravure ionique réactive.

De préférence, la couche d'oxyde est gravée par un procédé de gravure plasma.

De préférence, la plaque en matériau sans déformations plastiques est gravée par technique de gravure ionique réactive profonde DRIE.

De préférence, le matériau sans déformations plastiques est choisi parmi le silicium, la céramique, le quartz, le verre, le carbure de silicium.

De préférence, la plaque de silicium est une plaque de silicium pur, de silicium dopé, ou une plaque de silicium sur isolant ou encore une plaque de silicium sur un support. Le silicium est mono- ou polycristallin.

De préférence, le procédé comprend une étape supplémentaire dans laquelle un traitement de surface est réalisé sur le ou les composant micromécaniques en silicium obtenus pour obtenir une couche d'oxyde de silicium sur toute la surface du composant micromécanique d'un épaisseur supérieure à la couche de dioxyde de silicium dit « natif » se formant naturellement en présence d'air.

De préférence, le composant horloger obtenu par le procédé comprend une structuration formée d'au moins une ouverture, et de préférence, de la répétition d'ouvertures dont le rapport d'aspect est supérieur à 20, favorablement supérieur à 50, encore plus favorablement supérieur à 100.

Ainsi, on réalise un procédé de fabrication de composant micromécanique en matériau sans déformations plastiques, notamment en silicium, qui offre de grandes définition et précision de fabrication. Le procédé permet d'obtenir une meilleure résolution de gravure, de réduire les défauts sur les flancs de gravure et de réaliser des structures de moins de 5$\mu$m de dimensions de façon précise et répétable. Il devient donc possible de fabriquer des composant micromécaniques horlogers rigides ou déformables présentant une structuration pour les alléger (masse ou inertie) ou pour modifier une caractéristique mécanique (rigidité...) ou encore pour stopper une amorce de rupture dans les zones de contrainte. La réduction de défaut sur les flancs de gravure permet d'augmenter la résistance mécanique du composant micromécanique, ce qui donne plus de liberté pour le dimensionnement des composant micromécaniques, notamment des composant micromécaniques flexibles. Enfin, la précision de la gravure réduit la dispersion géométrique sur la plaque lorsque l'on grave plusieurs fois le même composant micromécanique (par exemple, réduction du nombre de classes pour les spiraux). Cela se traduit par une amélioration du rendement du procédé de fabrication.

Le procédé de fabrication selon l'invention s'applique à de nombreux composant micromécaniques horlogers rigides ou flexibles : comme des ressorts (lame ou spiral), des balanciers, des aiguilles, des ancres, des roues comme les roues d'échappement, des guidages flexibles...

**Revendications**

1. Procédé de fabrication d'au moins un composant micromécanique en matériau sans déformations plastiques, notamment en silicium, comprenant les étapes suivantes :

   a) se procurer une plaque matériau sans déformations plastiques, notamment en silicium (1) ;
   b) former une couche d'oxyde (2) au moins sur une surface de la plaque (1) ;
   c) appliquer une couche métallique (3) sur la couche d'oxyde (2) ;
   d) appliquer une couche de résine photosensible (4) sur la couche métallique (3) ;
   e) former par lithographie un premier masque de gravure (40) dans la couche de résine (4), le premier masque de gravure (40) comportant au moins un motif correspondant au composant horloger à fabriquer ;
   f) graver la couche métallique (3) à travers le premier masque de gravure (40) pour former un second masque de gravure (30) dans ladite couche métallique (3) ;
   g) graver la couche d'oxyde (2) à travers le second masque de gravure (30) pour former un troisième masque de gravure (20) dans ladite couche d'oxyde (2) ;
   h) graver la plaque (1) à travers le troisième masque de gravure (20) pour former ledit au moins un composant micromécanique.

2. Procédé selon la revendication 1, **caractérisé par le fait que** l'étape de lithographie est une étape de photolithographie à l'aide d'un stepper.

3. Procédé selon l'une des revendications précédentes, **caractérisé par le fait que** la couche métallique (3) est une couche de chrome, de titane ou de tantale.

4. Procédé selon l'une des revendications 1 ou 2, **caractérisé par le fait que** l'on applique une couche d'accroche sur la couche d'oxyde avant la couche métallique (3) et **par le fait que** ladite couche métallique (3) est une couche de nickel, tungstène, iridium ou aluminium.

5. Procédé selon l'une de revendications précédentes, **caractérisé par le fait que** la couche d'oxyde (2) présente une épaisseur comprise entre 0.4 et 3 $\mu$m.

6. Procédé selon l'une de revendications précédentes, **caractérisé par le fait que** la couche métallique (3) déposée sur la couche d'oxyde (2) présente une épaisseur de quelques centaines de nanomètres, de préférence entre 100 et 500 nanomètres.

7. Procédé selon l'une de revendications précédentes, **caractérisé par le fait que** la couche de résine (4) peut présenter une épaisseur entre 0.1 et 5 $\mu$mm, plus favorablement entre 0.2 et 3$\mu$m et de manière encore plus privilégiée entre 0.4 et 0.8 $\mu$m.

8. Procédé selon l'une de revendications précédentes, **caractérisé par le fait que** la couche métallique (3) est gravée par une technique de gravure ionique réactive.

9. Procédé selon l'une de revendications précédentes, **caractérisé par le fait que** la couche d'oxyde (2) est gravée par un procédé de gravure plasma.

10. Procédé selon l'une de revendications précédentes, **caractérisé par le fait que** la plaque en matériau sans déformations plastiques (1) est gravée par une technique de gravure ionique réactive profonde DRIE.

11. Procédé selon l'une de revendications précédentes, **caractérisé par le fait que** le matériau sans déformations plastiques est choisi parmi le silicium, la céramique, le quartz, le verre ou le carbure de silicium.

12. Procédé selon l'une de revendications précédentes, **caractérisé par le fait que** le procédé comprend une étape supplémentaire dans laquelle un traitement de surface est réalisé sur le ou les composants micromécaniques horlogers en silicium obtenus pour obtenir une couche d'oxyde de silicium de compensation sur toute la surface du composant micromécanique d'un épaisseur supérieure à la couche de dioxyde de silicium dit « natif » se formant naturellement en présence d'air.

13. Procédé selon l'une de revendications précédentes, **caractérisé par le fait que** la plaque de silicium (1) est une plaque de silicium pur, de silicium dopé, ou une plaque de silicium sur isolant ou encore une plaque de silicium sur un support.

14. Procédé selon l'une de revendications précédentes, **caractérisé par le fait que** le composant micromécanique obtenu par le procédé comprend une structuration formée d'au moins une ouverture dont le rapport d'aspect est supérieur à 20, favorablement supérieur à 50, encore plus favorablement supérieur à 100.

15. Composant micromécanique en matériau sans déformations plastiques, notamment en silicium, obtenu par un procédé de fabrication selon l'une des revendications précédentes, **caractérisé par le fait qu'**il comprend une structuration formée d'au moins une ouverture dont le rapport d'aspect défini par le rapport entre la hauteur de l'ouverture et sa largeur est supérieur à 20, favorablement supérieur à 50, encore plus favorablement supérieur à 100.

Fig. 1a

1

Fig. 1b

2

1

Fig. 1c

3

2

1

Fig. 1d

4

3

2

1

Fig. 1e

40     4
3
2
1

Fig. 1f

40     4
3
2
30     1

Fig. 1g

30     3
2
20     1

Fig. 1h

30     2
51     1
50   52

Fig. 2

Europäisches
Patentamt

European
Patent Office

Office européen
des brevets

# RAPPORT DE RECHERCHE EUROPEENNE

Numéro de la demande

EP 23 19 5373

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | HAN JONG ET AL: "In situ microtensile stage for electromechanical characterization of nanoscale freestanding films", REVIEW OF SCIENTIFIC INSTRUMENTS, AMERICAN INSTITUTE OF PHYSICS, 2 HUNTINGTON QUADRANGLE, MELVILLE, NY 11747, vol. 77, no. 4, 3 avril 2006 (2006-04-03), pages 45102-045102, XP012093012, ISSN: 0034-6748, DOI: 10.1063/1.2188368 | 1,4-8, 10,11,13 | INV. B81C1/00 |
| Y | * le document en entier * | 2,3,9, 12,14 | |
| | ----- | | |
| X | TW 201 133 600 A (SILECS OY [FI]) 1 octobre 2011 (2011-10-01) | 15 | |
| Y | * abrégé * * alinéa [0003] – alinéa [0121] * * figures 1-5 * | 14 | |
| | ----- | | |
| Y | US 2002/142620 A1 (YAN PEI-YANG [US] ET AL) 3 octobre 2002 (2002-10-03) | 2,3 | |
| A | * abrégé * * colonne 1 – colonne 3 * | 4 | |
| | ----- | | |
| Y | US 5 001 083 A (D ANNA PABLO E [US]) 19 mars 1991 (1991-03-19) | 9 | |
| A | * abrégé * * colonne 1 – colonne 2 * | 2-4 | |
| | ----- | | |
| Y | WO 2014/006229 A1 (ROLEX SA [CH]) 9 janvier 2014 (2014-01-09) * abrégé * * colonne 8, ligne 9 – ligne 25 * ----- | 12 | |

DOMAINES TECHNIQUES RECHERCHES (IPC)

B81C
B81B

Le présent rapport a été établi pour toutes les revendications

| Lieu de la recherche | Date d'achèvement de la recherche | Examinateur |
|---|---|---|
| Berlin | 31 janvier 2024 | Guidoin, M |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

............................................................

& : membre de la même famille, document correspondant

EPO FORM 1503 03.82 (P04C02)

## ANNEXE AU RAPPORT DE RECHERCHE EUROPEENNE
## RELATIF A LA DEMANDE DE BREVET EUROPEEN NO.

**EP 23 19 5373**

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

**31-01-2024**

| Document brevet cité au rapport de recherche | | Date de publication | Membre(s) de la famille de brevet(s) | | Date de publication |
|---|---|---|---|---|---|
| TW 201133600 | A | 01-10-2011 | AUCUN | | |
| US 2002142620 | A1 | 03-10-2002 | US | 2002142620 A1 | 03-10-2002 |
| | | | US | 2003203289 A1 | 30-10-2003 |
| US 5001083 | A | 19-03-1991 | AUCUN | | |
| WO 2014006229 | A1 | 09-01-2014 | CN | 104583880 A | 29-04-2015 |
| | | | EP | 2870512 A1 | 13-05-2015 |
| | | | JP | 6407146 B2 | 17-10-2018 |
| | | | JP | 6550176 B2 | 24-07-2019 |
| | | | JP | 2015522152 A | 03-08-2015 |
| | | | JP | 2018173425 A | 08-11-2018 |
| | | | US | 2015185701 A1 | 02-07-2015 |
| | | | US | 2019271947 A1 | 05-09-2019 |
| | | | WO | 2014006229 A1 | 09-01-2014 |

EPO FORM P0460

Pour tout renseignement concernant cette annexe : voir Journal Officiel de l'Office européen des brevets, No.12/82

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- CH 699476

- EP 3882710 A